# FASCICULE DE BREVET EUROPEEN

(11) **EP 3 389 428 B1**
(45) Date de publication et mention de la délivrance du brevet: **27.11.2019**
(21) Numéro de dépôt: 16805462.5
(22) Date de dépôt: 05.12.2016
(51) Int. Cl.: A44C 27/00, G04B 37/22, C23C 8/36, C23C 8/80, C23C 18/00

(54) **ELEMENT D'HABILLAGE EN ZIRCONE A ZONES SELECTIVEMENT CONDUCTRICES POUR APPLICATIONS ÉLECTRONIQUES**
VERKLEIDUNGSELEMENT AUS ZIRKON MIT SELEKTIV LEITENDEN ZONEN FÜR ELEKTRONISCHE ANWENDUNGEN
ZIRCONIA PANEL ELEMENT WITH SELECTIVELY CONDUCTIVE AREAS FOR ELECTRONIC APPLICATIONS

(30) Priorité: 18.12.2015 EP 15201257
(43) Date de publication de la demande: 24.10.2018
(73) Titulaire: The Swatch Group Research and Development Ltd, 2074 Marin (CH)
(72) Inventeur: CURCHOD, Loïc, 1004 Lausanne (CH); SPRINGER, Simon, 3007 Bern (CH)
(74) Mandataire: ICB SA
(86) Numéro de dépôt international: PCT/EP2016/079714
(87) Numéro de publication internationale: WO 2017/102399

(56) Documents cités:
- EP-A1- 0 287 746
- EP-A1- 0 850 900
- EP-A1- 1 548 524
- EP-A1- 2 725 000
- EP-A1- 2 856 903
- DE-A1- 2 446 431
- GB-A- 1 488 696
- US-A- 5 800 617
- US-A1- 2015 122 774

## Description

La présente invention concerne un élément d'habillage et son procédé de fabrication réalisé en céramique du type zircone dont la conductivité est modifiée sélectivement.

### ART ANTERIEUR

EP0850900 divulgue un élément d'habillage pour objet portable, l'élément d'habillage étant réalisé dans un premier matériau, le premier matériau étant un matériau céramique isolant (Zircone en l'occurrence), et pour lequel la surface dudit élément d'habillage est au moins partiellement traitée de sorte à présenter une transformation pourvue d'une conductivité électrique non-nulle. Il est connu des objets portables comme des montres ou des bracelets qui sont en partie réalisés en céramique. Une céramique connue est la zircone ZrO₂.

Par ailleurs, la tendance actuelle des objets portables est d'aller vers de plus en plus de fonctionnalités électroniques et de connectivité.

Cette augmentation de la technologie embarquée par les montres se présente sous la forme de l'intégration de moyens de commande tactiles offrant une utilisation plus intuitive et ludique ou se présente sous la forme de l'intégration de fonctions de communication sans fil, la montre pouvant alors communiquer avec un autre appareil comme un smartphone.

Toutefois, cette augmentation des fonctionnalités électroniques pose problème car elle implique une augmentation des composants et imposent des contraintes additionnelles sur les pièces d'habillage. Pour la communication, il est nécessaire d'avoir une antenne impliquant un support d'antenne et un connecteur pour relier l'antenne au module électronique principal. La zone où se trouve l'antenne doit être libre de pièces conductrices électriquement afin d'avoir les meilleures propriétés de transmission possibles.

De même, dans le cas de touches tactiles, il est nécessaire d'avoir des électrodes et donc d'avoir des moyens permettant de supporter ces électrodes et des moyens pour connecter ces électrodes au module électronique principal. Ces électrodes doivent aussi pouvoir être isolées électriquement d'éléments conducteurs perturbateurs.

On constate donc que l'intégration de nouvelles technologies a tendance à ajouter des composants et des contraintes, ce qui implique une miniaturisation et une adaptation de ceux-ci est donc une augmentation des coûts ou une augmentation de la taille du boitier de la montre ou un changement esthétique.

Il existe donc un besoin pour trouver une solution à cette augmentation des fonctionnalités électroniques dans une montre.

### RESUME DE L'INVENTION

La présente invention a pour but de pallier les inconvénients de l'art antérieur en proposant un élément d'habillage selon la revendication 1.

A cet effet, l'invention concerne un élément d'habillage pour un objet portable réalisé dans un premier matériau, le premier matériau étant un matériau céramique isolant, la surface dudit élément d'habillage est au moins partiellement traitée de sorte à présenter au moins une transformation pourvue d'une conductivité électrique non nulle.

Cette invention permet d'avoir un élément d'habillage qui présente des zones isolantes et des zones présentant une conductivité électrique telle qu'il est possible de les utiliser pour des applications de type pistes conductrices, antennes, circuits électroniques ou électrodes pour touches tactiles.

Dans un premier mode de réalisation, le premier matériau est de la zircone.

Dans un second mode de réalisation, la surface est sélectivement traitée pour être transformée en carbure de zirconium dont la conductivité est non-nulle.

Dans un troisième mode de réalisation, la surface est sélectivement traitée pour être transformée en nitrure de zirconium dont la conductivité est non-nulle.

Selon l'invention, la surface comprend au moins une creusure, la surface étant traitée pour être transformée en carbure ou nitrure, puis polie pour localiser cette transformation au niveau de ladite creusure.

Selon l'invention, la surface comprend au moins une partie saillante, la surface étant traitée pour être transformée en carbure ou nitrure, puis polie pour exclure cette transformation de ladite partie saillante.

Dans un autre mode de réalisation, la surface est transformée en carbure ou nitrure de manière homogène, puis usinée localement pour localiser la transformation sur les parties non-usinées.

La présente invention concerne aussi un objet portable comprenant un tel élément d'habillage.

Dans un premier mode de réalisation, ledit objet portable est une pièce d'horlogerie comprenant un boitier formé par une carrure, munie d'une lunette, fermée par un fond et une glace, ledit objet portable comprenant en outre des moyens de commande, et un bracelet avec son fermoir fixé à la carrure via deux paires de cornes, et en ce que l'élément d'habillage est choisi pour être agencé dans la liste comprenant la carrure, la lunette, les moyens de commande, le fond, le bracelet ou le fermoir.

Dans un autre mode de réalisation, ledit objet portable comprend en outre un module électronique apte à utiliser ladite surface traitée de sorte à présenter au moins une transformation pourvue d'une conductivité électrique non nulle pour opérer au moins une fonction.

Dans un autre mode de réalisation, la surface traitée de sorte à présenter au moins une transformation pourvue d'une conductivité électrique non nulle sera une antenne pour opérer une fonction de communication.

Dans un autre mode de réalisation, la surface traitée de sorte à présenter au moins une transformation pourvue d'une conductivité électrique non nulle sera une électrode pour opérer une fonction de commande.

Dans un autre mode de réalisation, la surface traitée de sorte à présenter au moins une transformation pourvue d'une conductivité électrique non nulle sera une paroi utilisée dans une fonction blindage permettant d'isoler un module ou composant électronique des perturbations d'un autre module ou composant électronique.

Dans un autre mode de réalisation, la surface traitée de sorte à présenter au moins une transformation pourvue d'une conductivité électrique non nulle sera au moins une piste conductrice permettant de relier électriquement un module ou composant électronique à au moins un autre module ou composant électronique.

La présente invention concerne en outre un procédé de traitement d'un élément d'habillage pour un objet portable réalisé dans un premier matériau, le premier matériau étant un matériau céramique isolant, ledit procédé comprenant les étapes suivantes :
- Se munir de l'élément d'habillage et le placer dans une enceinte fermée hermétiquement et contenant une atmosphère chargée atomiquement d'un élément chimique ;
- Chauffer localement, par l'intermédiaire d'une première source de chaleur focalisée comme par exemple un laser, la surface de l'élément d'habillage de sorte que les atomes de l'atmosphère de l'enceinte se combinent localement avec la surface du premier matériau à l'endroit où ladite surface est chauffée.

Dans un premier mode de réalisation, l'atmosphère est créée par dissociation d'un gaz via la même source de chaleur chauffant localement la surface de l'élément d'habillage.

Dans un deuxième mode de réalisation, l'atmosphère est créée par dissociation d'un gaz via une seconde source de chaleur indépendante de celle qui chauffe localement la surface de l'élément d'habillage.

Dans un troisième mode de réalisation, l'atmosphère est créée par dissociation d'un gaz via une deuxième source de chaleur indépendante de la première source qui chauffe localement la surface de l'élément d'habillage, l'élément d'habillage étant chauffé de manière homogène via une troisième source de chaleur à une température plus faible que celle permettant la combinaison des atomes de l'atmosphère avec le premier matériau, la première source de chaleur servant à élever localement la température de la surface de l'élément d'habillage afin de permettre la combinaison des atomes de l'atmosphère avec le premier matériau.

Dans une première variante, ledit procédé comprend les étapes suivantes :
- Se munir de l'élément d'habillage ;
- Déposer localement sur la surface dudit élément d'habillage une couche métallique qui agira comme un masque pour limiter la carburation ou la nitruration de la zircone aux zones de la surface de l'élément d'habillage non-protégées par le dépôt métallique ;
- Placer ledit élément d'habillage dans une enceinte fermée hermétiquement et contenant une atmosphère chargée atomiquement d'un élément chimique et chauffer la surface de l'élément d'habillage de sorte que les atomes du composé de l'atmosphère de l'enceinte se combinent avec la surface du premier matériau non recouverte du dépôt métallique ;
- Attaquer sélectivement et chimiquement la surface dudit élément d'habillage afin de retirer le dépôt métallique afin de confiner les zones conductrices aux zones non-couvertes par le dépôt métallique lors de l'étape de carburation/nitruration.

Dans un premier mode de réalisation, le dépôt métallique sélectif est réalisé par dépôt au travers d'un masque préalablement posé sur l'élément d'habillage.

Dans un second mode de réalisation, le dépôt métallique sélectif est réalisé par dépôt suivi d'une étape de structuration par laser de la surface dudit élément d'habillage.

Dans un troisième mode de réalisation, le dépôt métallique sélectif est réalisé par dépôt suivi d'une étape de photolithographie de la surface dudit élément d'habillage.

Dans un quatrième mode de réalisation, l'étape consistant à déposer une couche métallique sélective consiste à déposer une couche d'épargne sur la totalité de la surface dudit élément d'habillage puis à graver sélectivement cette couche d'épargne selon une forme désirée puis à déposer la coche métallique sur la totalité de la surface dudit élément d'habillage, la couche d'épargne restant étant ensuite enlevée par attaque chimique.

Dans une seconde variante, ledit procédé comprend les étapes suivantes :
- Se munir de l'élément d'habillage ;
- Traiter ledit élément d'habillage en le plaçant dans une enceinte fermée hermétiquement et contenant une atmosphère chargée atomiquement d'un élément chimique et en chauffant sa surface de sorte que les atomes de l'atmosphère de l'enceinte se combinent avec la surface du premier matériau ;
caractérisé en ce que ledit procédé comprend en outre, préalablement ou postérieurement à l'étape consistant à traiter ledit élément d'habillage, une étape de structuration de l'élément d'habillage permettant la création de relief sur sa surface.

Dans un premier mode de réalisation, lorsque l'étape de structuration de l'élément d'habillage est réalisée postérieurement à l'étape consistant à traiter la surface dudit élément d'habillage, la structuration ôte la couche superficielle sur les zones structurées et la localise sur les zones non-structurées.

Dans un second mode de réalisation, le procédé comprend en outre, lorsque l'étape de structuration de l'élément d'habillage est réalisée antérieurement à l'étape consistant à traiter la surface dudit élément d'habillage, une étape de polissage pour enlever la couche superficielle sur la partie haute de la surface en relief de l'élément d'habillage et localiser ainsi les zones conductrices aux creusures non-touchées par le polissage.

### BREVE DESCRIPTION DES FIGURES

Les buts, avantages et caractéristiques de l'invention apparaîtront plus clairement dans la description détaillée suivante d'au moins une forme de réalisation de l'invention donnée uniquement à titre d'exemple non limitatif et illustrée par les dessins annexés sur lesquels :
- Les figures 1 et 2 représentent schématiquement l'objet portable selon l'invention;
- Les figures 3 à 5 représentent schématiquement un premier mode de réalisation du procédé selon l'invention;
- Les figures 6 à 20 représentent schématiquement un second mode de réalisation du procédé selon l'invention;
- Les figures 21 et 22 représentent schématiquement un troisième mode de réalisation du procédé selon l'invention;

### DESCRIPTION DETAILLEE

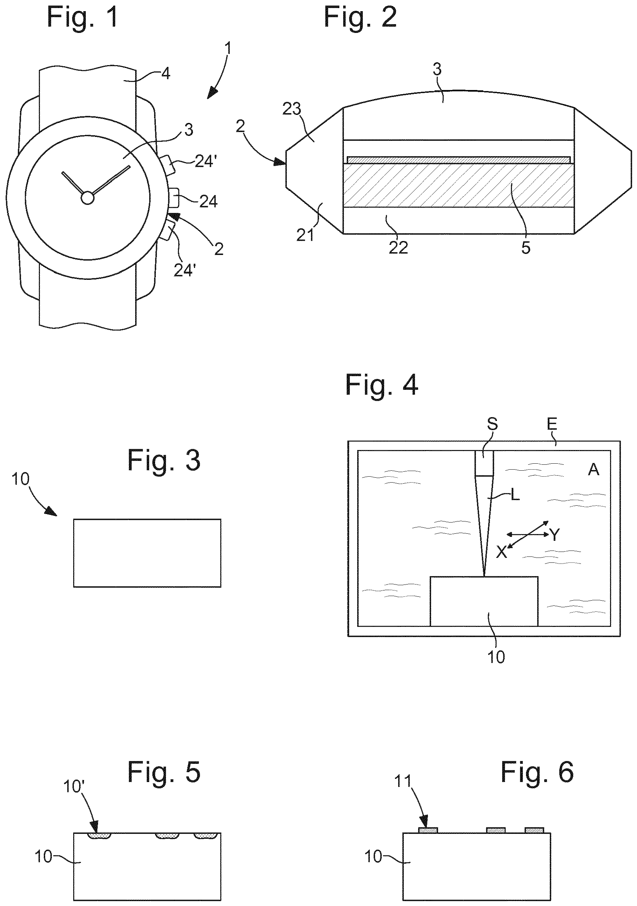

Sur les figures 1 et 2, un objet portable 1 selon l'invention est décrit. Un exemple d'objet portable selon l'invention est une pièce d'horlogerie. Une telle pièce d'horlogerie comprend un boitier 2 formé par une carrure 21 fermée par un fond 22 et une glace 3. Ce boitier 2 renferme un module électronique pouvant être un mouvement horloger 5 électronique ou électromécanique. Ce module électronique peut être associé à un autre élément comme un mouvement mécanique. Cette objet portable peut également comprendre un bracelet 4 comprenant deux brins 4' ou une pluralité de maillons. Un élément d'habillage selon l'invention est donc compris dans la liste comprenant la carrure, la lunette, le fond, le bracelet, le fermoir, la boucle déployante ou la boucle - ardillon nécessaire à la fermeture du bracelet. Bien entendu, la montre peut également comprendre une lunette 23, tournante ou non, intégrée ou non à la carrure, ainsi que des moyens de commande comme une tête de couronne 24 ou des boutons-poussoirs 24'. La carrure 21 pourra être munie d'une lunette intégrée ou rapportée.

L'élément d'habillage selon l'invention est réalisé dans un premier matériau. Ce matériau est choisi pour être du type céramique. La céramique utilisée ici est de l'oxyde de zirconium ZrO₂ également appelé zircone.

Avantageusement selon l'invention, cet élément d'habillage 10 en céramique est traité en surface. Ce traitement en surface est opéré de sorte à être sélectif c'est-à-dire que l'élément d'habillage 10 n'est pas obligatoirement traité sur l'intégralité de sa surface. Ce traitement de surface est utilisé afin d'obtenir un changement de conductivité électrique sur des zones spécifiques.

Dans un premier mode de réalisation visible aux figures 3 à 5, le traitement selon la présente invention consiste en une carburation/nitruration sélective de l'élément d'habillage 10 par une source de chaleur focalisée, comme un laser. Pour rappel, une carburation/nitruration consiste à activer la pièce à carburer/nitrurer en la chauffant dans une atmosphère chargée en atomes de carbone ou d'azote.

La première étape consiste donc à se munir de l'élément d'habillage 10 qui sera traitée et à le placer dans une enceinte E. Cette enceinte E est fermée hermétiquement et contient une atmosphère A chargée en atomes de carbone C ou d'azote N suivant que l'on pratique une carburation ou nitruration. Cette atmosphère A chargée en atomes de carbone C ou d'azote N peut être créée par dissociation de composés tel que le méthane CH4, le diazote N₂ ou l'ammoniac NH₃. Cette dissociation est opérer en chauffant les composés de base pour briser les liaisons moléculaires et obtenir des atmosphères atomiques.

La seconde étape consiste à carburer ou nitrurer sélectivement l'élément d'habillage 10 en activant par chauffage la surface de la pièce dans des zones choisies 10'. Pour pouvoir chauffer sélectivement ladite surface dans les zones choisies 10', une source de chaleur focalisée S, e.g. un laser fournissant un faisceau laser L, est utilisée. Ce faisceau laser est préférentiellement pulsé. La surface de l'élément d'habillage 10 est alors chauffée localement dans les zones 10' à une température comprise entre 700 et 1100°C pendant une durée de 30 à 180 minutes. Sous l'effet de cette température les atomes de carbone ou d'azote de l'atmosphère A de l'enceinte E se combinent avec la surface en zircone dans les zones 10' de l'élément d'habillage 10. Il s'agit d'une transformation de la surface des zones 10' de l'élément d'habillage 10 sur une faible épaisseur, de l'ordre de 10 à 500 nm, en carbure de zirconium ou nitrure de zirconium ayant un aspect métallique de couleur platine ou proche de l'or jaune respectivement, et une conductivité non-nulle. Il s'agit donc d'une modification superficielle de la structure de la zircone en une nouvelle structure cristallographique correspondant à celle du carbure de zirconium/nitrure de zirconium et non d'un revêtement rapporté susceptible d'être arraché ou de se désolidariser de la surface de l'article, notamment lorsque celui-ci est soumis à des conditions d'usure importante. Plus particulièrement, la couche superficielle qui présente la structure du carbure de zirconium ou du nitrure de zirconium s'étend à partir de la surface sur une profondeur comprise entre 10 et 500 nm.

Or, le carbure de zirconium et le nitrure de zirconium présentent une conductivité électrique non nulle au contraire de la zircone qui est considérée comme un matériau isolant. De ce fait, les zones qui sont carburées ou nitrurées présentent une conductivité électrique non nulle. Comme le reste de l'élément d'habillage n'est pas transformé, on se retrouve avec des zones conductrices entourées de zones isolantes.

Pour opérer les différentes étapes, il peut être prévu plusieurs modes d'exécution.

Dans un premier mode d'exécution, la dissociation des gaz pour obtenir une atmosphère chargée en atomes de carbone C ou d'azote N et l'activation locale de la surface dudit élément d'habillage utilisent le même laser.

Dans un second mode d'exécution, la dissociation des gaz pour obtenir une atmosphère chargée en atomes de carbone C ou d'azote N est opérée par une première source de chaleur alors que l'activation locale de la surface dudit élément d'habillage 10 utilise le laser.

Dans un troisième mode d'exécution, la dissociation des gaz pour obtenir une atmosphère chargée en atomes de carbone C ou d'azote N est opérée par une première source de chaleur, l'élément d'habillage 10 est chauffé via une seconde source de chaleur alors que l'activation locale de la surface de l'élément d'habillage utilise le laser. Ce troisième mode d'exécution permet de préchauffer l'élément d'habillage 10 de manière homogène et d'avoir un écart de température moins élevé dans la zone de la surface de l'élément d'habillage 10 traitée par la source de chaleur focalisée.

Un avantage de ce premier mode de réalisation est qu'il permet aisément une activation sélective de la surface de l'élément d'habillage 10. En effet, un faisceau laser présente l'avantage d'avoir un diamètre de faisceau réglable.

Dans un second mode de réalisation visible aux figures 6 à 20, le principe utilise une métallisation sélective comme masque pour obtenir une carburation ou nitruration sélective de la surface de l'élément d'habillage 10.

La première étape consiste donc à se munir de l'élément d'habillage 10 et de lui apposer une métallisation 11 sur sa surface. Cette métallisation est sélective c'est-à-dire qu'elle est effectuée sur la ou les zones que l'on désire carburer ou nitrurer. Ce dépôt métallique est réalisé par exemple dans un matériau compris dans la liste incluant le Chrome, le Tantale, le Molybdène, le Tungstène, le Niobium, le Titane, le Silicium et est réalisé selon plusieurs modes d'exécution.

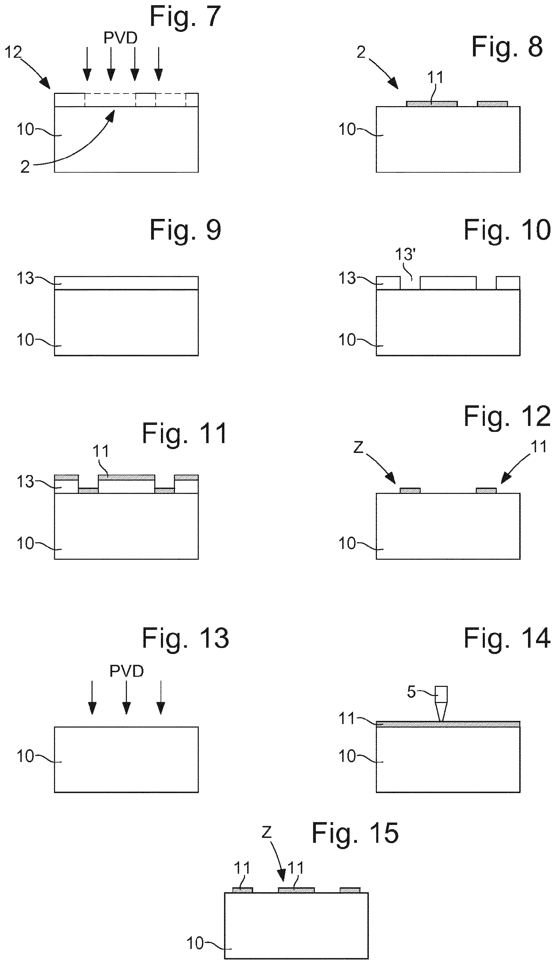

Dans un premier mode d'exécution visible aux figures 7 et 8, la métallisation est réalisée par masquage de la surface de l'élément d'habillage 10 via un masque 12 suivi par une déposition métallique via un procédé du type dépôt physique en phase vapeur PVD. Ainsi, seules les zones Z non recouvertes par le masque reçoivent le dépôt de métal 11.

Dans un second mode d'exécution visible aux figures 9 à 12, la métallisation est réalisée en déposant une couche d'épargne 13 comme une couche de capton ou une couche d'encre ou de laque ou de résine sur la surface de l'élément d'habillage. Cette couche 13 est alors sélectivement gravée selon l'esthétisme voulu et laisse apparaitre des ouvertures 13'. Le tout est alors recouvert d'une couche métallique 11 par dépôt PVD, la couche se déposant tant sur la couche d'épargne 13 que dans les creusures faites dans ladite épargne. Enfin la couche d'épargne 13 est enlevée par attaque chimique laissant la couche métallique 11 uniquement sur les zones Z correspondant aux endroits des creusures 13' de l'épargne retirée.

Dans un troisième mode d'exécution visible aux figures 13 à 15, le dépôt métallique sélectif consiste à déposer sur métal 11 sur la totalité de la surface de l'élément d'habillage 10 pour ensuite utiliser une source de chaleur focalisée S tel un laser pour structurer la couche métallique 11 déposée. Cette structuration consiste en un décapage de la surface de l'élément d'habillage 10 pour enlever la couche métallique 11 aux endroits non désirés et laissant la couche métallique 11 sur les zones désirées Z.

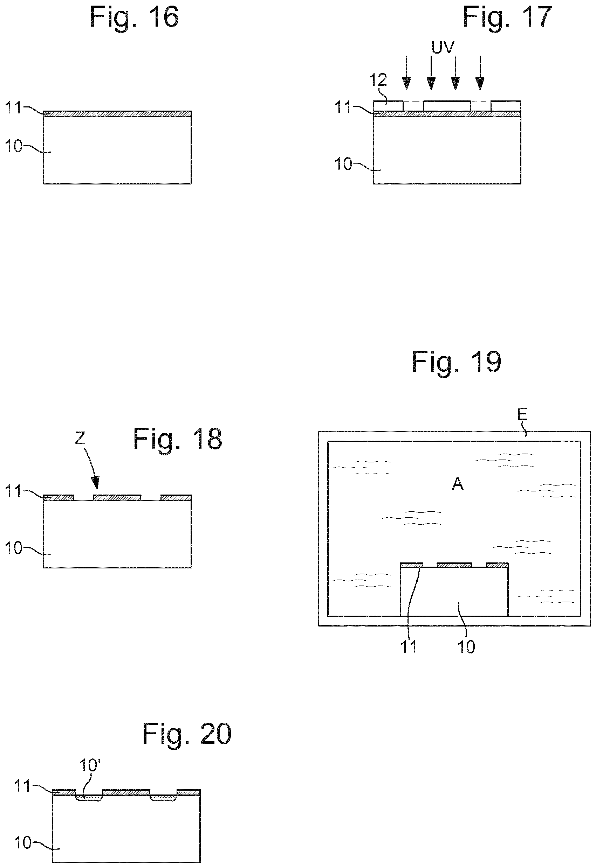

Dans un quatrième mode d'exécution visible aux figures 16 à 18, le dépôt métallique sélectif consiste à déposer le métal sur la totalité de la surface de l'élément d'habillage 10. Suite à cela, une étape de photolithographie est utilisée avec un masque 12 pour modifier localement la couche métallique 11 déposée. Cette modification locale est suivie d'une étape d'attaque chimique pour enlever la couche métallique 11 aux endroits non désirés et la laisser sur les zones désirées Z.

Une fois ce dépôt métallique réalisé, l'étape suivante consiste à carburer ou nitrurer l'élément d'habillage 10 avec la couche métallique 11 sur les zones Z de sa surface. Pour cela, l'élément d'habillage 10 est placé dans une enceinte E qui contient une atmosphère A chargée en atomes de carbone C ou d'azote N, comme indiqué à la figure 19. Le tout est alors chauffé en utilisant une technique plasma telle que décrite dans le brevet EP 0 850 900. Or, le dépôt métallique 11 fait ici office de bouclier empêchant la carburation/nitruration des zones recouvertes par ce dépôt métallique 11 et permettant la transformation aux zones 10' non recouvertes comme visible à la figure 20.

Dans une étape suivante, le dépôt métallique 11 est chimiquement dissout pour laisser apparaitre la zircone dans sa couleur d'origine. On obtient donc un élément d'habillage ayant une zone mise à nue et une zone carburée/nitrurée et donc conductrice.

Dans un troisième mode de réalisation, la transformation sélective de de la surface de l'élément d'habillage en zone conductrice utilise le principe de carburation/nitruration et structuration.

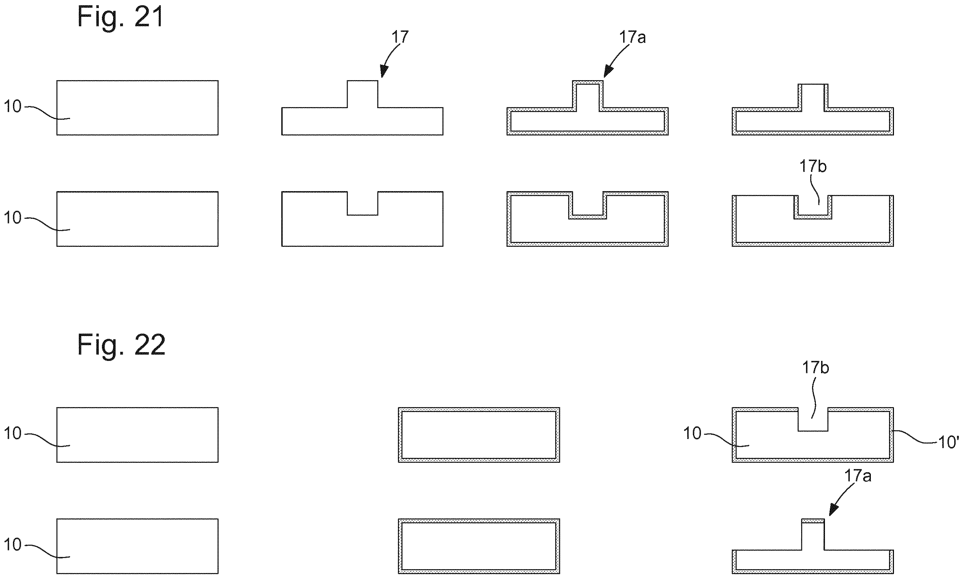

Dans un premier mode d'exécution visible à la figure 21, la première étape consiste à se munir de l'élément d'habillage 10 en zircone. Cette première étape consiste également à structurer cet élément d'habillage 10. Cette structuration peut être opérée de deux manières différentes : Durant la fabrication de l'élément d'habillage 10 ou postérieure à cette fabrication.

Dans le cas où la structuration est réalisée pendant la fabrication de l'élément d'habillage, on comprendra que cette fabrication consiste à mélanger entre elles des poudres pour ensuite les mettre dans un moule et les fritter c'est à dire les soumettre à une température et une pression telle qu'une transformation s'opère. Ainsi, le moule dans lequel les poudres sont placées peut avoir une forme incluant les reliefs, structurations désirés.

Dans le cas où la structuration est réalisée postérieurement à la fabrication de l'élément d'habillage, un usinage mécanique ou laser est envisageable.

Dans une seconde étape, l'élément d'habillage est carburé ou nitruré. Pour cela, l'élément d'habillage 10 structuré est placé dans une enceinte E dans laquelle se trouve une atmosphère A chargée en atomes de carbone ou d'azote. Le tout est alors chauffé via un plasma durant une durée déterminée afin de transformer la surface de l'élément d'habillage 10 en carbure ou nitrure de zirconium conducteur respectivement. Cette carburation/nitruration est donc réalisée sur la totalité de la surface de l'élément d'habillage.

Dans une troisième étape, l'élément d'habillage subit une étape de polissage. Cette étape de polissage consiste à enlever la couche superficielle de l'élément d'habillage 10. Or, l'élément d'habillage 10 est munie de structurations 17 se présentant sous la forme de creux 17b ou de parties saillantes 17a, ces creux 17b ou parties saillantes 17a étant eux aussi carburés/nitrurés. Par conséquent, le polissage ne concerne pas l'intégralité de la surface de l'élément d'habillage 10. Effectivement, dans le cas où les structurations 17 sont des creusures, l'opération de polissage laisse la carburation/nitruration, c'est-à-dire les parties conductrices, dans les creusures. Dans le cas où les structurations 17 sont des parties saillantes, l'opération de polissage enlève la carburation/nitruration au niveau de ces parties saillantes.

Ainsi, on obtient un relief dont les creusures sont sélectivement conductrices.

Dans un second mode d'exécution visible à la figure 22, la première étape consiste à se munir de l'élément d'habillage en zircone.

Dans une seconde étape, ledit élément d'habillage est carburé/nitruré. Pour cela, l'élément d'habillage 10 structuré est placé dans une enceinte dans laquelle se trouve une atmosphère chargée en atomes de carbone ou d'azote. Le tout est alors chauffé via un plasma durant une durée déterminée afin de transformer la surface de l'élément d'habillage en carbure ou nitrure de zirconium conducteur respectivement. Cette carburation/nitruration est donc réalisée sur la totalité de la surface de l'élément d'habillage.

Dans une troisième étape, l'élément d'habillage 10 subit une étape de structuration. Cette étape consiste à enlever de la matière de l'élément d'habillage. Pour cela, un usinage mécanique ou laser est utilisé. L'enlèvement de matière peut être opéré de sorte à n'enlever localement que la couche superficielle de 10 à 500 nm qui est transformée en carbure ou nitrure. Toutefois, l'enlèvement de matière peut être opéré de sorte à accentuer le relief au niveau des zones conductrices.

Cette transformation de l'élément d'habillage en surface pour présenter des zones ayant une conductivité électrique permet de réaliser des pistes conductrices pour relier électriquement un module ou composant électronique à au moins un autre module ou composant électronique, des antennes intégrées, ainsi que des électrodes pour des touches ou commandes tactiles. Ces zones ayant une conductivité électrique non nulle seront utilisées par le module électronique de l'objet portable. Ces zones ayant une conductivité électrique non nulle permettent également d'opérer une fonction blindage c'est-à-dire permettant d'isoler un module ou composant électronique des perturbations d'un autre module ou composant électronique.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention défini par les revendications annexées.

Ainsi, on comprendra que l'élément d'habillage peut être traitée à différents endroits sur sa surface.

## Revendications

1. Elément d'habillage (10) pour objet portable, l'élément d'habillage étant réalisé dans un premier matériau, le premier matériau étant un matériau céramique isolant, **caractérisé en ce que** la surface dudit élément d'habillage est traitée localement de façon à ce que la surface comporte une zone isolante et une zone conductrice, la zone conductrice présentant au moins une transformation pourvue d'une conductivité électrique non nulle et **en ce que** ladite surface comprend :
- au moins une creusure (17b), la surface étant traitée pour être transformée en carbure ou nitrure et polie pour localiser cette transformation au niveau de ladite creusure, ou
- au moins une partie saillante (17a), la surface étant traitée pour être transformée en carbure ou nitrure et polie pour exclure cette transformation de ladite partie saillante.

2. Elément d'habillage selon la revendication 1, **caractérisé en ce que** le premier matériau est de la zircone.

3. Elément d'habillage selon les revendications 1 ou 2, **caractérisé en ce que** la surface est sélectivement traitée pour être transformée en carbure.

4. Elément d'habillage selon les revendications 1 ou 2, **caractérisé en ce que** la surface est sélectivement traitée pour être transformée en nitrure.

5. Objet portable comprenant l'élément d'habillage selon l'une des revendications précédentes.

6. Objet portable selon la revendication 5, **caractérisé en ce que** ledit objet portable est une pièce d'horlogerie comprenant un boitier (2) formé par une carrure (21), munie d'une lunette, fermée par un fond (22) et une glace (3), ledit objet portable comprenant en outre des moyens de commande (24, 24'), et un bracelet (4) fixé à la carrure via deux paires de cornes, et **en ce que** l'élément d'habillage est choisi pour être agencé dans la liste comprenant la carrure, la lunette, les moyens de commande, le fond, le bracelet ou le fermoir.

7. Objet portable selon la revendication 6, **caractérisé en ce que** ledit objet portable comprend en outre un module électronique (5) apte à utiliser ladite surface traitée de sorte à présenter au moins une transformation pourvue d'une conductivité électrique non nulle pour opérer au moins une fonction.

8. Objet portable selon la revendication 7, **caractérisé en ce que** la surface traitée de sorte à présenter au moins une transformation pourvue d'une conductivité électrique non nulle sera une antenne pour opérer une fonction de communication.

9. Objet portable selon les revendications 7 ou 8, **caractérisé en ce que** la surface traitée de sorte à présenter au moins une transformation pourvue d'une conductivité électrique non nulle sera une électrode pour opérer une fonction de commande.

10. Objet portable selon l'une des revendications 7 à 9, **caractérisé en ce que** la surface traitée de sorte à présenter au moins une transformation pourvue d'une conductivité électrique non nulle sera une paroi utilisée dans une fonction blindage permettant d'isoler un module ou composant électronique des perturbations d'un autre module ou composant électronique.

11. Objet portable selon l'une des revendications 7 à 10, **caractérisé en ce que** la surface traitée de sorte à présenter au moins une transformation pourvue d'une conductivité électrique non nulle sera au moins une piste conductrice permettant de relier électriquement un module ou composant électronique à au moins un autre module ou composant électronique.

12. Procédé de traitement d'un élément d'habillage (10) pour objet portable selon l'une quelconque des revendications 5 à 11, l'élément d'habillage étant réalisé dans un premier matériau, le premier matériau étant un matériau céramique isolant, ledit procédé comprenant les étapes suivantes :
• Se munir de l'élément d'habillage et le placer dans une enceinte (E) fermée hermétiquement et contenant une atmosphère chargée atomiquement d'un élément chimique ;
• Chauffer localement, par l'intermédiaire d'une première source de chaleur (S) focalisée, la surface de l'élément d'habillage de sorte que les atomes de l'atmosphère de l'enceinte se combinent avec une partie de la surface du premier matériau pour former à la surface de l'élément d'habillage au moins une zone isolante et une zone conductrice.

13. Procédé de traitement selon la revendication 12, **caractérisé en ce que** l'atmosphère est créée par dissociation d'un gaz via une seconde source de chaleur.

14. Procédé de traitement selon la revendication 13, **caractérisé en ce que** l'atmosphère est créée par dissociation d'un gaz via une seconde source de chaleur, l'élément d'habillage étant chauffé à une température plus faible que la température d'activation de la combinaison des atomes de l'atmosphère avec la surface du premier matériau via une troisième source de chaleur.

15. Procédé de traitement d'un élément d'habillage (10) pour objet portable selon l'une quelconque des revendications 5 à 11, l'élément d'habillage étant réalisé dans un premier matériau, le premier matériau étant un matériau céramique isolant, ledit procédé comprenant les étapes suivantes :
• Se munir de l'élément d'habillage ;
• Déposer localement sur la surface dudit élément d'habillage une couche métallique (11);
• Placer ledit élément d'habillage dans une enceinte fermée hermétiquement et contenant une atmosphère chargée atomiquement d'un élément chimique et chauffer la surface de l'élément d'habillage de sorte que les atomes de l'atmosphère de l'enceinte se combinent avec une partie de la surface du premier matériau non recouverte du dépôt métallique pour former à la surface de l'élément d'habillage une zone conductrice ;
• Attaquer sélectivement et chimiquement la surface dudit élément d'habillage afin de retirer le dépôt métallique.

16. Procédé de traitement selon la revendication 15, **caractérisé en ce que** le dépôt métallique sélectif est réalisée par dépôt au travers d'un masque (12) préalablement posé sur l'élément d'habillage.

17. Procédé de traitement selon la revendication 15, **caractérisé en ce que** le dépôt métallique sélectif est réalisée par dépôt suivi d'une étape de structuration par laser de la surface dudit élément d'habillage.

18. Procédé de traitement selon la revendication 15, **caractérisé en ce que** le dépôt métallique sélectif est réalisée par dépôt suivi d'une étape de photolithographie de la surface dudit élément d'habillage.

19. Procédé de traitement selon la revendication 15, **caractérisé en ce que** l'étape consistant à déposer une couche métallique (11) consiste à déposer une couche d'épargne (13) sur la totalité de la surface dudit élément d'habillage puis à graver sélectivement cette couche d'épargne selon une forme désirée puis à déposer la couche métallique (11) sur la totalité de la surface dudit élément d'habillage, la couche d'épargne restante étant ensuite enlevée par attaque chimique, laissant ainsi la couche métallique aux endroits où la couche d'épargne était préalablement gravée.

20. Procédé de traitement d'un élément d'habillage (10) pour objet portable selon l'une quelconque des revendications 5 à 11 réalisé dans un premier matériau, le premier matériau étant un matériau céramique isolant, ledit procédé comprenant les étapes suivantes :
• Se munir de l'élément d'habillage ;
• Traiter ledit élément d'habillage en le plaçant dans une enceinte fermée hermétiquement et contenant une atmosphère chargée atomiquement d'un élément chimique et en chauffant sa surface de sorte que les atomes de l'atmosphère de l'enceinte se combinent avec la surface du premier matériau;
**caractérisé en ce que** ledit procédé comprend en outre, préalablement ou postérieurement à l'étape consistant à traiter ledit élément d'habillage, une étape de structuration de l'élément d'habillage permettant la création de relief (17) sur sa surface et de localiser la couche carburée/nitrurée conductrice dans les parties saillantes ou les creusures du relief.

21. Procédé de traitement selon la revendication 20, **caractérisé en ce qu'**il comprend en outre, lorsque l'étape de structuration de l'élément d'habillage est réalisée antérieurement à l'étape consistant à traiter ledit élément d'habillage, une étape de polissage pour enlever la couche superficielle carburée/nitrurée sur les parties saillantes de la surface en relief de l'élément d'habillage.

## Patentansprüche

1. Verkleidungselement (10) für einen tragbaren Gegenstand, wobei das Verkleidungselement aus einem ersten Material hergestellt ist, und das erste Material ein isolierendes keramisches Material ist, **dadurch gekennzeichnet, dass** die Oberfläche des Verkleidungselements lokal derart bearbeitet wird, dass die Oberfläche eine isolierende Zone und eine leitende Zone aufweist, wobei die leitende Zone mindestens eine Transformation aufweist, die eine von null verschiedene elektrische Leitfähigkeit aufweist, und dass die Oberfläche umfasst:
- mindestens eine Einsenkung (17b), wobei die zu behandelnde Oberfläche in Carbid oder Nitrid umgewandelt und poliert wird, um diese Transformation in Bezug auf die Einsenkung auszuführen, oder
- mindestens ein vorstehendes Teil (17a), wobei die zu behandelnde Oberfläche in Carbid oder Nitrid umgewandelt und poliert wird, um den vorstehenden Teil von der Transformation auszunehmen.

2. Verkleidungselement nach Anspruch 1, **dadurch gekennzeichnet, dass** das erste Material Zirkonoxid ist.

3. Verkleidungselement nach Anspruch 1 oder 2, **dadurch gekennzeichnet, dass** die Oberfläche selektiv bearbeitet wird, um in Carbid umgewandelt zu werden.

4. Verkleidungselement nach den Ansprüchen 1 oder 2, **dadurch gekennzeichnet, dass** die Oberfläche selektiv bearbeitet wird, um in Nitrid umgewandelt zu werden.

5. Tragbarer Gegenstand, der das Verkleidungselement nach einem der vorhergehenden Ansprüche umfasst.

6. Tragbarer Gegenstand nach Anspruch 5, **dadurch gekennzeichnet, dass** der tragbare Gegenstand eine Uhr ist, umfassend ein Gehäuse (2), das durch einen mit einer Lünette versehenen und durch einen Boden (22) und ein Glas (3) verschlossenen Gehäusemittelteil (21) gebildet ist, wobei der tragbare Gegenstand ferner Steuermittel (24, 24') und ein an den Gehäusemittelteil über zwei Hörnerpaare befestigtes Armband (4) umfasst, und dass das Verkleidungselement so gewählt ist, dass es in dem Verzeichnis, das den Gehäusemittelteil, die Lünette, die Steuermittel, den Boden, das Armband oder die Schließe umfasst, enthalten ist.

7. Tragbarer Gegenstand nach Anspruch 6, **dadurch gekennzeichnet, dass** der tragbare Gegenstand ferner ein elektronisches Modul (5) umfasst, das geeignet ist, die Oberfläche zu verwenden, die derart bearbeitet ist, dass sie mindestens eine mit einer von null verschiedenen elektrischen Leitfähigkeit versehene Transformation aufweist, um mindestens eine Funktion auszuführen.

8. Tragbarer Gegenstand nach Anspruch 7, **dadurch gekennzeichnet, dass** die Oberfläche, die derart bearbeitet ist, dass sie mindestens eine mit einer von null verschiedenen elektrischen Leitfähigkeit versehene Transformation aufweist, eine Antenne zum Ausführen einer Kommunikationsfunktion ist.

9. Tragbarer Gegenstand nach den Ansprüchen 7 oder 8, **dadurch gekennzeichnet, dass** die Oberfläche, die derart bearbeitet ist, dass sie mindestens eine mit einer von null verschiedenen elektrischen Leitfähigkeit versehene Transformation aufweist, eine Elektrode zum Ausführen einer Steuerfunktion ist.

10. Tragbarer Gegenstand nach einem der Ansprüche 7 bis 9, **dadurch gekennzeichnet, dass** die Oberfläche, die derart bearbeitet ist, dass sie mindestens eine mit einer von null verschiedenen elektrischen Leitfähigkeit versehene Transformation aufweist, eine Wand mit einer Abschirmungsfunktion ist, die ermöglicht, ein Modul oder eine elektronische Komponente von Störungen eines anderen Moduls oder einer anderen elektronischen Komponente zu isolieren.

11. Tragbarer Gegenstand nach einem der Ansprüche 7 bis 10, **dadurch gekennzeichnet, dass** die Oberfläche, die derart bearbeitet ist, dass sie mindestens eine mit einer von null verschiedenen elektrischen Leitfähigkeit versehene Transformation aufweist, mindestens eine Leiterbahn ist, die ermöglicht, ein Modul oder eine elektronische Komponente mit mindestens einem anderen Modul oder einer anderen elektronischen Komponente elektrisch zu verbinden.

12. Verfahren zum Bearbeiten eines Verkleidungselements (10) für einen tragbaren Gegenstand nach einem der Ansprüche 5 bis 11, wobei das Verkleidungselement aus einem ersten Material hergestellt ist, das erste Material ein isolierendes keramisches Material ist, und das Verfahren die folgenden Schritte umfasst:
- Bereitstellen eines Verkleidungselements und Anordnen desselben in einem hermetisch geschlossenen Behälter (E), der eine mit einem chemischen Element atomar geladene Atmosphäre enthält;
- lokales Erhitzen der Oberfläche des Verkleidungselements mittels einer ersten fokussierten Wärmequelle (2) derart, dass sich die Atome der Atmosphäre des Behälters mit einem Teil der Oberfläche des ersten Materials vereinen, um auf der Oberfläche des Verkleidungselements mindestens eine isolierende Zone und mindestens eine leitende Zone zu bilden.

13. Bearbeitungsverfahren nach Anspruch 12, **dadurch gekennzeichnet, dass** die Atmosphäre durch Dissoziation eines Gases mittels einer zweiten Wärmequelle erzeugt wird.

14. Bearbeitungsverfahren nach Anspruch 13, **dadurch gekennzeichnet, dass** die Atmosphäre durch Dissoziation eines Gases mittels einer zweiten Wärmequelle erzeugt wird, wobei das Verkleidungselement mittels einer dritten Wärmequelle auf eine Temperatur erwärmt wird, die niedriger ist als die Aktivierungstemperatur für das Vereinen der Atome der Atmosphäre mit der Oberfläche des ersten Materials.

15. Verfahren zum Bearbeiten eines Verkleidungselements (10) für einen tragbaren Gegenstand nach einem der Ansprüche 5 bis 11, wobei das Verkleidungselement aus einem ersten Material hergestellt ist, das erste Material ein isolierendes keramisches Material ist, und das Verfahren die folgenden Schritte umfasst:
- Bereitstellen des Verkleidungselements;
- lokales Ablagern einer Metallschicht (11) auf der Oberfläche des Verkleidungselements;
- Anordnen des Verkleidungselements in einem hermetisch geschlossenen Behälter, der eine mit einem chemischen Element atomar geladene Atmosphäre enthält, und Erwärmen der Oberfläche des Verkleidungselements derart, dass die Atome der Atmosphäre des Behälters sich mit einem nicht mit der metallischen Ablagerung bedeckten Teil der Oberfläche des ersten Materials vereinen, um auf der Oberfläche des Verkleidungselements eine leitende Zone zu bilden;
- selektives und chemisches Ätzen der Oberfläche des Verkleidungselements, um die metallische Ablagerung zu entfernen.

16. Bearbeitungsverfahren nach Anspruch 15, **dadurch gekennzeichnet, dass** die selektive metallische Ablagerung durch eine Ablagerung durch eine vorab auf dem Verkleidungselement angeordnete Maske (12) hindurch erfolgt.

17. Bearbeitungsverfahren nach Anspruch 15, **dadurch gekennzeichnet, dass** die selektive metallische Ablagerung durch eine Ablagerung, gefolgt von einem Schritt zum Laserstrukturieren der Oberfläche des Verkleidungselements, erfolgt.

18. Bearbeitungsverfahren nach Anspruch 15, **dadurch gekennzeichnet, dass** die selektive metallische Ablagerung durch eine Ablagerung, gefolgt von einem Schritt der Fotolithographie der Oberfläche des Verkleidungselements, erfolgt.

19. Bearbeitungsverfahren nach Anspruch 15, **dadurch gekennzeichnet, dass** der Schritt, bestehend aus dem Ablagern einer Metallschicht (11), darin besteht, eine Abdeckschicht (13) auf der gesamten Oberfläche des Verkleidungselements abzulagern, dann diese Abdeckschicht gemäß einer gewünschten Form selektiv zu gravieren, anschließend die Metallschicht (11) auf der gesamten Oberfläche des Verkleidungselements abzulagern, wobei die verbleibende Abdeckschicht anschließend durch chemische Ätzung abgehoben wird, wodurch die Metallschicht an den Stellen, an denen die Abdeckschicht vorher graviert worden ist, verbleibt.

20. Verfahren zum Bearbeiten eines Verkleidungselements (10) für einen tragbaren Gegenstand nach einem der Ansprüche 5 bis 11, der aus einem ersten Material hergestellt ist, wobei das erste Material ein isolierendes keramisches Material ist, und das Verfahren die folgenden Schritte umfasst:
- Bereitstellen des Verkleidungselements;
- Bearbeiten des Verkleidungselements und Anordnen desselben in einem hermetisch geschlossenen Behälter, der eine mit einem chemischen Element atomar geladene Atmosphäre enthält, und Erwärmen seiner Oberfläche derart, dass die Atome der Atmosphäre des Behälters sich mit der Oberfläche des ersten Materials vereinen;
**dadurch gekennzeichnet, dass** das Verfahren ferner vor oder nach dem Schritt, bestehend aus der Bearbeitung des Verkleidungselements, einen Schritt zum Strukturieren des Verkleidungselements umfasst, der die Erzeugung eines Reliefs (17) auf der Oberfläche und die Ausführung der leitenden carburierten/nitrierten Schicht in den vorstehenden Teilen oder in den Einsenkungen des Reliefs ermöglicht.

21. Bearbeitungsverfahren nach Anspruch 20, **dadurch gekennzeichnet, dass** es ferner dann, wenn der Schritt zum Strukturieren des Verkleidungselements vor dem Schritt ausgeführt wird, der darin besteht, das Verkleidungselement zu bearbeiten, einen Schritt des Polierens umfasst, um die carburierte/nitrierte Oberflächenschicht auf den vorstehenden Teilen der reliefartigen Oberfläche des Verkleidungselements abzuheben.

## Claims

1. External part (10) for a portable object, the external part being made of a first material, the first material being an insulating ceramic material, **characterised in that** the surface of said external part is locally treated such that the surface includes an insulating region and a conductive region, the conductive region having at least one converted portion with non-zero electrical conductivity and **in that** said surface comprises:
- at least one recess (17b), the surface being treated so as to be converted into carbide or nitride and polished in order to localise this converted portion at said hollow, or
- at least one protruding part (17a), the surface being treated so as to be converted into carbide or nitride and polished in order to exclude this converted portion from said hollow.

2. External part according to claim 1, **characterised in that** the first material is zircon ia.

3. External part according to claims 1 or 2, **characterised in that** the surface is selectively treated so as to be converted into carbide.

4. External part according to claims 1 or 2, **characterised in that** the surface is selectively treated so as to be converted into nitride.

5. Portable object comprising the external part according to one of the preceding claims.

6. Portable object according to claim 5, **characterised in that** said portable object is a timepiece comprising a case (2) formed by a middle part (21), provided with a bezel, closed by a back (22) and a glass (3), said portable object further comprising control means (24, 24'), and a bracelet (4) fastened to the middle part via two pairs of horns, and **in that** the external part is chosen such that it is arranged in the list consisting of the middle part, the bezel, the control means, the back, the bracelet, or the clasp.

7. Portable object according to claim 6, **characterised in that** said portable object further comprises an electronic module (5) capable of using said treated surface so as to have at least one converted portion with non-zero electrical conductivity in order to carry out at least one function.

8. Portable object according to claim 7, **characterised in that** the surface treated so as to have at least one converted portion with non-zero electrical conductivity will be an antenna in order to carry out a communication function.

9. Portable object according to claims 7 or 8, **characterised in that** the surface treated so as to have at least one converted portion with non-zero electrical conductivity will be an electrode in order to carry out a control function.

10. Portable object according to one of claims 7 to 9, **characterised in that** the surface treated so as to have at least one converted portion with non-zero electrical conductivity will be a wall used in a shielding function allowing an electronic component or module to be insulated from interference from another electronic component or module.

11. Portable object according to one of claims 7 to 10, **characterised in that** the surface treated so as to have at least one converted portion with non-zero electrical conductivity will be at least one conductive track allowing an electronic component or module to be electrically connected to at least one other electronic component or module.

12. Method for treating an external part (10) for a portable object according to any of claims 5 to 11, the external part being made of a first material, the first material being an insulating ceramic material, said method comprising the steps of:
- obtaining the external part and placing same in a hermetically-sealed chamber (E) containing an atmosphere atomically charged with a chemical element;
- locally heating, by way of a first focused heat source (S), the surface of the external part such that the atoms of the atmosphere of the chamber combine with a part of the surface of the first material in order to form, on the surface of the external part, at least one insulating region and one conductive region.

13. Treatment method according to claim 12, **characterised in that** the atmosphere is created by dissociating a gas via a second heat source.

14. Treatment method according to claim 13, **characterised in that** the atmosphere is created by dissociating a gas via a second heat source, the external part being heated to a temperature that is lower than the activation temperature for the combination of the atoms of the atmosphere with the surface of the first material via a third heat source.

15. Method for treating an external part (10) for a portable object according to any of claims 5 to 11, the external part being made of a first material, the first material being an insulating ceramic material, said method comprising the steps of:
- obtaining the external part;
- locally depositing a metal layer (11) on the surface of said external part;
- placing said external part in a hermetically-sealed chamber containing an atmosphere atomically charged with a chemical element and heating the surface of the external part such that the atoms of the atmosphere of the chamber combine with a part of the surface of the first material that is not covered by the metal deposit in order to form a conductive region on the surface of the external part;
- selectively and chemically etching the surface of said external part in order to remove the metal deposit.

16. Treatment method according to claim 15, **characterised in that** the selective metal deposition is carried out by deposition through a mask (12) previously placed on the external part.

17. Treatment method according to claim 15, **characterised in that** the selective metal deposition is carried out by deposition followed by a step of structuring the surface of said external part by a laser.

18. Treatment method according to claim 15, **characterised in that** the selective metal deposition is carried out by deposition followed by a step of carrying out photolithography on the surface of said external part.

19. Treatment method according to claim 15, **characterised in that** the step of depositing a metal layer (11) consists of depositing a resist layer (13) on the entirety of the surface of said external part, then of selectively etching this resist layer to a desired form, then of depositing the metal layer (11) on the entirety of the surface of said external part, the remaining resist layer then being removed by chemical etching, thus leaving the metal layer in locations where the resist layer was previously etched.

20. Method for treating an external part (10) for a portable object according to any of claims 5 to 11, made of a first material, the first material being an insulating ceramic material, said method comprising the steps of:
- obtaining the external part;
- treating said external part by placing it in a hermetically-sealed chamber containing an atmosphere atomically charged with a chemical element and heating the surface thereof such that the atoms of the atmosphere of the chamber combine with the surface of the first material;
**characterised in that** said method further comprises, prior or subsequently to the step of treating said external part, a step of structuring the external part, allowing a raised portion (17) to be created on the surface thereof and localising the carburised/nitrided conductive layer in the protruding parts or recesses of the raised portion.

21. Treatment method according to claim 20, **characterised in that** it further comprises, when the step of structuring the external part is carried out prior to the step of treating said external part, a polishing step in order to remove the carburised/nitrided surface layer from the protruding parts of the raised surface of the external part.
